# FASCICULE DE BREVET EUROPEEN

(11) **EP 0 730 564 B1**
(45) Date de publication et mention de la délivrance du brevet: **30.07.1997**
(21) Numéro de dépôt: 95902173.4
(22) Date de dépôt: 24.11.1994
(51) Int. Cl.: C04B 41/87, C23C 16/04, C04B 41/50, C23C 16/34

(54) **PROCEDE DE DENSIFICATION D'UNE STRUCTURE POREUSE PAR DU NITRURE DE BORE**
VERFAHREN ZUR VERDICHTUNG EINER PORÖSEN STRUKTUR MIT BORNITRID
METHOD FOR DENSIFYING A POROUS STRUCTURE USING BORON NITRIDE

(30) Priorité: 26.11.1993 FR 9314182
(43) Date de publication de la demande: 11.09.1996
(73) Titulaire: COMMISSARIAT A L'ENERGIE ATOMIQUE, 75015 Paris (FR)
(72) Inventeur: DAVID, Patrick, F-75014 Paris (FR); BENAZET, Jean, D., F-91220 Bretigny-sur-Orge (FR); NARCY, Bruno, F-75014 Paris (FR)
(74) Mandataire: Des Termes, Monique
(86) Numéro de dépôt international: FR9401371
(87) Numéro de publication internationale: WO9514645

(56) Documents cités:
- JOURNAL OF COMPOSITE MATERIALS, vol.9, Juillet 1975 pages 228 - 240 H. O. PIERSON 'Boron Nitride Composites by Chemical Vapor Deposition' cité dans la demande
- PROCEEDINGS OF THE 4TH CVD CONFERENCE, 1973 pages 460 - 472 J.J. GEBHARDT 'CVD Boron Nitride Infiltration of Fibrous Structures: Properties of Low Temperature Deposits' cité dans la demande
- CHEMICAL ABSTRACTS, vol. 106, no. 14, 6 Avril 1987, Columbus, Ohio, US; abstract no. 106847d, H. TANJI, ET AL. page 298
- CHEMICAL ABSTRACTS, vol. 104, no. 20, 19 Mai 1986, Columbus, Ohio, US; abstract no. 173212q, Y.HOSHINO page 293
- CHEMICAL ABSTRACTS, vol. 115, no. 10, 9 Septembre 1991, Columbus, Ohio, US; abstract no. 103333h, M. NISHIMURA ET AL page 761

## Description

La présente invention concerne un procédé de densification d'une structure poreuse par du nitrure de bore permettant de densifier par exemple, des tissus ou des feutres bi- ou multidirectionnels ou des céramiques poreuses. La densification consiste à remplir les vides de la matrice poreuse de façon à entraîner une augmentation de la densité de celle-ci.

L'invention concerne également une structure poreuse densifiée par du nitrure de bore.

Le nitrure de bore présente des propriétés particulièrement intéressantes qui sont rappelées ci-après :
- légèreté,
- excellente inertie chimique, c'est-à-dire résistance aux acides et aux métaux fondus et absence de réaction chimique avec le carbone ou le dioxyde de carbone jusqu'à 1800°C,
- bonne stabilité thermique (jusqu'à 2200°C sous atmosphère inerte et jusqu'à 2400°C sous azote),
- bon comportement lors de l'ablation,
- bon conducteur thermique,
- résistivité électrique élevée,et
- bonnes propriétés mécaniques.

Grâce à ces propriétés spécifiques, le nitrure de bore est traditionnellement utilisé dans la réalisation de fours sous-vide utilisés à haute température, dans le domaine de la fonderie, dans les procédés de transformation de métaux très purs ou d'alliages pour obtenir une coulée continue des aciers, par exemple. Il est également employé dans le revêtement de fibres de carbone afin de protéger celles-ci de l'oxydation ou de servir d'interface d'adaptation entre les fibres et les matrices de composite céramique.

Le nitrure de bore est potentiellement utilisable pour d'autres applications très importantes dans le domaine de l'aéronautique ou dans le domaine spatial, par exemple dans la fabrication de fenêtres d'antennes, de freins d'avions, de boucliers thermiques ou de corps de rentrée (dans l'atmosphère) diélectriques. En effet, le nitrure de bore s'oxyde beaucoup moins rapidement que les matrices carbone-carbone et constitue un très bon isolant électrique. Toutefois, pour ces dernières applications, le nitrure de bore sous forme de céramique ne convient pas, en raison de sa trop grande fragilité vis-à-vis des chocs thermiques ou mécaniques. Pour y remédier, il faudrait pouvoir disposer de matériaux sous forme de composites comprenant une matrice renforcée par des fibres tissées, comme cela est déjà le cas pour la majorité des composés non métalliques du type carbone, carbure, borure, nitrure ou oxyde, .

Plusieurs techniques ont été étudiées dans l'art antérieur pour élaborer des matériaux composites à matrice en nitrure de bore.

On connaît ainsi une première technique utilisant la voie gazeuse ou infiltration chimique en phase vapeur. Cette technique est développée de manière industrielle pour le carbone et le carbure de silicium et consiste à faire réagir chimiquement par chauffage des espèces gazeuses au sein d'un réseau poreux appelé préforme. Cette technique présente de nombreux inconvénients. Il est en effet difficile d'obtenir une densification homogène et importante puisqu'il faut éviter la fermeture prématurée des pores se trouvant à la périphérie de la pièce à densifier. En outre, ce procédé est extrêmement lent et l'on peut atteindre des durées d'élaboration de plusieurs mois pour des pièces de grandes dimensions.

Parmi ces techniques de dépôt en phase vapeur, on connaît d'après l'article de J.J. GEBHARDT, "Proceedings of the 4th CVD Conference (compte rendu de la 4ème conférence sur les dépôts chimiques en phase vapeur), 1973, pages 460-472, un procédé de densification de structures fibreuses en silice et en nitrure de bore, par décomposition thermique en phase vapeur d'un précurseur du nitrure de bore. Ce précurseur est par exemple la trichloroborazine (BClNH)₃. Selon ce document, la préforme poreuse est placée à l'intérieur d'une enceinte dans laquelle la trichloroborazine est introduite sous forme gazeuse, à une température d'environ 1100°C et sous des conditions de pression de 4.10² Pa. L'article précise également que des tentatives pour infiltrer du nitrure de bore à des températures plus élevées et à des pressions plus élevées conduit rapidement à une obturation des pores extérieurs de la préforme et limite la pénétration du précurseur et du nitrure de bore à l'intérieur de la structure poreuse.

L'article de Hugues H. PIERSON, "Boron Nitride Composites by Chemical Vapor Deposition", (composite de nitrure de bore par dépôt chimique en phase vapeur), J. Composite Materials, vol. 9, juillet 1975, pages 228-240, décrit un matériau composite formé par dépôt chimique en phase vapeur de nitrure de bore sur un substrat à base de fibres en nitrure de bore. Les gaz réactifs utilisés sont le trifluorure de bore (BF₃) et l'ammoniac (NH₃). Selon cet article, une préforme formée d'un feutre en nitrure de bore est introduite à l'intérieur d'une enceinte de dépôt CVD, au centre d'un suscepteur en graphite. Les bobines de chauffage par induction sont placées dans les parois de l'enceinte. Cette dernière est alimentée par les deux gaz précités. La température de réaction est comprise entre 1100 et 1200°C et la pression maintenue à l'intérieur de l'enceinte varie entre 40 et 53.10² Pa. On réalise ainsi la densification de la préforme.

Toutefois, les matériaux obtenus par les deux procédés précités comportent des défauts et notamment une densité faible et l'inclusion de composés non entièrement pyrolysés. En outre, ces matériaux composites présentent des fissures.

Une deuxième technique de densification consiste à réaliser une réaction en phase solide. Ce procédé est décrit dans l'article de Ruey Y. LIN, James ECONOMY et H. DEAN BATHA, "Preparation of BN/BN Composites (préparation de composites BN/BN) Ceramic Bulletin, vol. 55, n°9, 1976. Le procédé décrit dans cet article consiste à mélanger des fibres de nitrure de bore avec un précurseur partiellement nitruré, constitué d'un mélange de nitrure de bore et d'oxyde de bore B₂O₃ sous forme fibreuse, puis à effectuer un pressage isostatique à chaud de l'ensemble.

Enfin, on connaît également d'après la demande de brevet FR 2 684 366 un procédé de préparation de nitrure de bore par réaction de trichloroborazine avec un dérivé de formule ***N***_{**2**}***Si***_{***n***}***(CH***_{**3**}***)***_{**3*n***}***H***_{**4-*n***} (n étant égal à 2 ou 3) puis pyrolyse. Toutefois au cours de la pyrolyse, il n'a pas de passage en phase vapeur.

L'invention a pour objet de remédier aux inconvénients connus de l'art antérieur.

A cet effet, l'invention concerne un procédé de densification d'une structure poreuse par du nitrure de bore caractérisé en ce que l'on place la structure poreuse dans un précurseur choisi parmi les borazines de formule RBNH dans laquelle R est un halogène ou l'hydrogène et en ce que l'on chauffe l'ensemble par induction, à une température d'au moins 600°C, sous une pression d'au moins 1,2.10⁵ Pa, de façon à former, par décomposition du précurseur, du nitrure de bore susceptible de se déposer à l'intérieur des pores de ladite structure poreuse.

Grâce à ces caractéristiques de l'invention, ce procédé permet de densifier des structures poreuses en un temps très court de quelques heures, alors que tous les procédés de l'art antérieur ne permettaient d'obtenir une densification qu'au bout de plusieurs jours, voire plusieurs semaines. En outre, ce procédé permet d'obtenir une structure poreuse d'une densité élevée et des produits exempts de fissures. L'utilisation d'une pression importante permet d'éviter la décomposition du précurseur dans le réacteur et de maintenir en permanence du précurseur à l'intérieur de celui-ci.

De préférence, le précurseur choisi est la trichloroborazine (BClNH)₃.

D'autres caractéristiques et avantages de l'invention ressortiront mieux à la lecture de la description suivante, donnée à titre purement illustratif et non limitatif, cette description étant faite en faisant référence aux dessins joints, dans lesquels :
- la figure 1 représente de façon schématique un dispositif permettant la mise en oeuvre du procédé de l'invention, et
- la figure 2 est une courbe illustrant un exemple de cycle thermique de densification, en fonction du temps.

Selon l'invention, le procédé consiste à placer une structure poreuse de forme quelconque dans un précurseur du nitrure de bore, à chauffer l'ensemble par induction, sous pression, de façon à former du nitrure de bore susceptible de se déposer à l'intérieur des pores de la structure poreuse.

Ce procédé peut s'appliquer à la densification de substrats en carbone, graphite, alumine ou nitrure de bore, par exemple. D'une manière plus générale, la structure poreuse peut être de nature chimique quelconque, mais stable à la température de fonctionnement du procédé.

Le précurseur du nitrure de bore sélectionné correspond à la famille des borazines de formule (RBNH)₃ dans laquelle R est un halogène ou l'hydrogène. Cette famille de précurseur permet d'obtenir du nitrure de bore pur. De façon avantageuse, le précurseur est la trichloroborazine.

Les borazines sont des composés qui se décomposent et polymérisent rapidement lorsqu'ils sont portés à ébullition. En conséquence, il est nécessaire de réaliser la réaction sous pression de façon à diminuer fortement la décomposition du précurseur. On évite aussi la cristallisation du précurseur par augmentation de la température d'ébullition.

La réaction de densification est effectuée à une température d'au moins 600°C et de préférence d'au moins 1000°C environ et sous une pression d'au moins 1,2.10⁵ Pa et de préférence au moins 1,4.10⁵ Pa. La vitesse de densification est d'autant plus élevée que la température est élevée. En dessous d'une pression de 1,2.10⁵ Pa, le précurseur se décompose très rapidement et ceci entraîne sa disparition et l'arrêt du procédé de densification au bout de quelques minutes.

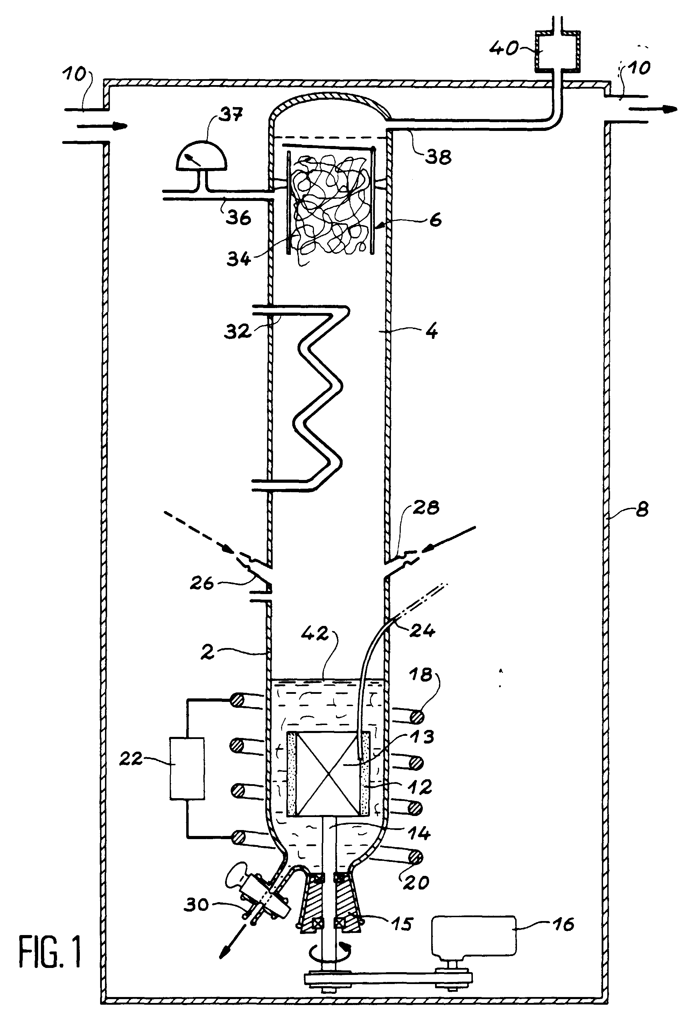

La figure 1 illustre un dispositif susceptible d'être utilisé pour la mise en oeuvre du procédé selon l'invention. Ce dispositif comprend trois parties, à savoir un réacteur 2, un condenseur ou échangeur de chaleur 4 et un dévésiculeur 6 ou piège à aérosol. Ce dispositif est placé à l'intérieur d'une boîte à gants 8, munie d'orifices d'entrée et de sortie 10 permettant le balayage de l'intérieur de la boîte à gants par un courant de gaz neutre. La boite à gants 8 assure la sécurité du manipulateur en cas de rupture du réacteur et permet d'éviter l'inflammation des gaz de réaction ou l'inhalation du produit par le manipulateur.

La structure poreuse à densifier 12 est placée sur un support rotatif ou non. Ce support 14 peut également supporter, en contact avec la structure poreuse, un suscepteur 13 (par exemple un mandrin en graphite de façon à pouvoir être chauffé par induction). Le support est monté dans la partie inférieure du corps du réacteur 2 et traverse un bouchon 15 muni d'une ouverture à travers laquelle peut coulisser le support 14. Le support 14 peut être mis en rotation au moyen d'un moteur 16 situé à l'extérieur du réacteur 2.

Le réacteur 2 est chauffé au moyen d'un dispositif de chauffage par induction 18 constitué de bobines 20 dans lesquelles peut circuler un courant haute fréquence fourni par un générateur 22. La température de la structure poreuse 12 est mesurée par des thermosondes 24 comprenant des thermocouples reliés à un programmateur permettant de réguler la puissance du générateur 22 afin de contrôler la température.

En outre, le réacteur comprend un conduit 26 permettant l'introduction du précurseur en continu à l'intérieur du réacteur 2, un conduit 28 d'injection d'azote ou d'un autre gaz neutre servant à chasser l'air contenu dans le réacteur 2 et enfin, un orifice 30 muni d'un robinet situé dans la partie inférieure du réacteur et permettant la vidange de celui-ci.

Le réacteur 2 est surmonté du condenseur ou échangeur de chaleur 4. Celui-ci comprend un serpentin 32 de circulation du liquide de refroidissement, (généralement de l'eau). L'échangeur de chaleur permet par refroidissement des vapeurs du précurseur et par condensation de celles-ci de les renvoyer dans le réacteur 2. En outre, le maintien d'une pression suffisante dans le dispositif permet d'éviter la cristallisation du précurseur au niveau de cet échangeur de chaleur.

Le dévésiculeur 6 se trouve en partie haute du dispositif. Il a pour rôle d'éliminer le brouillard créé au niveau du réacteur 2 et qui ne serait pas condensé au niveau de l'échangeur de chaleur 4. Ce dévésiculeur comprend un filtre 34, une vanne de régulation de pression 36 et un conduit 38 d'extraction du gaz de réaction. La vanne de régulation 36 est reliée à un manomètre 37 qui permet de réguler la pression à l'intérieur du dévésiculeur. Enfin, le dévésiculeur comprend un conduit 38 d'extraction du gaz de réaction qui permet de renvoyer le gaz vers une installation de traitement des gaz 40, généralement située hors de la boîte à gants 8.

On décrit ci-après la séquence opératoire permettant la densification d'un substrat poreux.

### Séquence opératoire :

On dispose la structure poreuse 12 sur le support 14 à l'intérieur du réacteur 2, puis l'on effectue un balayage du réacteur 2 à l'aide d'un gaz inerte, afin de chasser l'oxygène éventuellement présent à l'intérieur du réacteur. On remplit alors le réacteur 2 avec le précurseur 42 se présentant sous forme d'une poudre ou d'un liquide en fonction de la nature de celui-ci. Ce remplissage est effectué par l'intermédiaire du conduit de remplissage 26. Dans le cas de l'utilisation, la trichloroborazine, le précurseur est sous forme de poudre.

Après avoir mis en fonctionnement le circuit réfrigérant 32 et les alimentations électriques, c'est-à-dire le générateur 22, le programmateur et la thermosonde 24, on démarre la montée en température de la structure poreuse. La pression est fixée à 1,4.10⁵ Pa par l'intermédiaire du manomètre 37.

Dès que le précurseur 42 commence à fondre, (80°C pour la trichloroborazine), on supprime le balayage de gaz inerte. Le précurseur est alors sous forme liquide au contact de la structure poreuse et sous forme solide dans la partie la plus basse du réacteur. On augmente ensuite la puissance du chauffage jusqu'à ébullition et reflux du précurseur 42. Celui-ci, sous forme liquide, pénètre dans les pores de la structure poreuse.

Lorsque l'on atteint la température de "cracking" (600°C par exemple pour la trichloroborazine), les vapeurs de précurseur 42 subissent un "cracking" dans la structure poreuse 12, ce qui conduit au dépôt du nitrure de bore à l'intérieur des pores du substrat.

Plus précisément, le "cracking" se réalise au niveau des parois les plus chaudes de la structure poreuse. Lorsque la structure poreuse est montée sur un suscepteur, le front de densification se propage de l'intérieur de la structure poreuse cylindrique vers la paroi extérieure. Lorsqu'il n'y a pas de suscepteur ou dans le cas d'une structure poreuse monobloc (une plaque par exemple), le front de densification progresse depuis l'intérieur de la structure poreuse vers ses parois extérieures placées au contact du précurseur liquide. Le front de densification se propage dans le substrat poreux au cours du procédé de densification, à une vitesse qui peut varier entre quelques dizièmes de millimètres par heure et quelques centimètres par heure, en fonction de la température maximale du substrat échantillon et de sa nature.Les gaz de "cracking" ressortent par les pores non encore obturés.

Les gaz issus de la réaction sont évacués dans la partie supérieure de l'installation.

Le substrat est ensuite refroidi puis soumis à un traitement thermique à une température supérieure ou égale à 2000°C pendant au moins 1 heure, dans un four en dépression, sous azote (pression supérieure ou égale à 0,1.10⁵ Pa). Ce traitement thermique permet de stabiliser le nitrure de bore vis-à-vis de l'hydrolyse.

Les substrats densifiés obtenus après un tel traitement revèlent par micrographie optique en lumière polarisée des croix de Malte et des croissances colonaires caractéristiques, par analogie avec le carbone, de structure laminaire rugueuse. Cette structure est la plus intéressante car elle permet d'obtenir, par le traitement thermique à haute température (2000°C), une structure de type graphite.

Des examens au microscope électronique à transmission et l'analyse par diffraction X confirment l'existence d'une bonne orientation des cristallites.

Les matériaux composites obtenus ont une densité de 1,8 environ, une taille de cristallité Lₐ=50 à 100 nm, L_{c}=10 à 20 nm et une distance interplan dₒₒ₂ comprise entre 3,33 et 3,37.10⁻¹⁰ m (3,33 et 3,37 *Å*).

D'après l'art antérieur, on ne connaissait pas jusqu'à présent de matrice en nitrure de bore avec cet état de graphitation.

On décrit ci-après un exemple de fabrication d'un substrat densifié.

### Exemple :

Le substrat poreux à densifier 12 est une pièce parallélépipédique d'une hauteur de 10 cm, d'une largeur de 3 cm et d'une épaisseur de 1,5 cm constituée de fibres de carbone tissées suivant trois directions (fibres T300, 6K, 50A de marque déposée TORAY, 50% de fibres en volume). Une thermosonde est fixée au centre de la pièce. La pression est fixée à 1,4.10⁵Pa par l'intermédiaire du manomètre 37. Le réacteur 2 utilisé fait 200 mm de hauteur et présente un diamètre interne de 5 cm.

Le précurseur est la trichloroborazine.

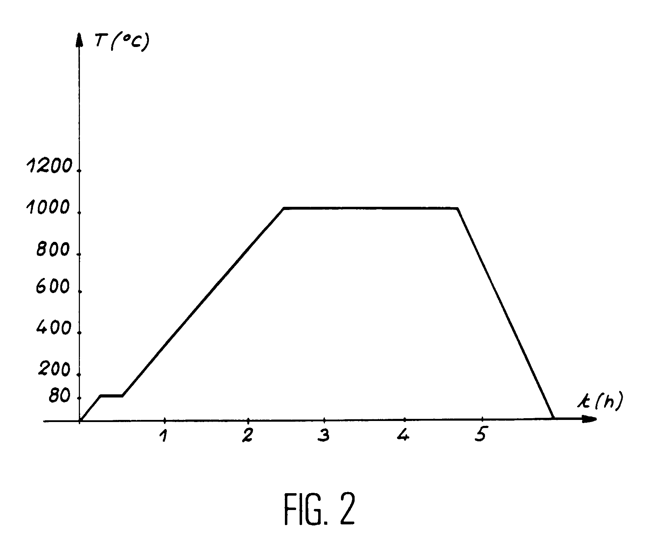

Le cycle de traitement thermique est illustré en figure 2. Après un premier plateau à 80°C pendant 15 minutes, la montée en température s'effectue à raison de 400°C/h environ jusqu'à 1000°C. Ensuite, le refroidissement s'effectue à raison d'une diminution de température de 800°C par heure.

La pièce obtenue subit un traitement thermique à 2000°C pendant 1 heure dans un four en dépression. La densité finale de la pièce est d'environ 1,8 et le nitrure de bore obtenu est de structure du type graphite précité.

## Revendications

1. Procédé de densification d'une structure poreuse par du nitrure de bore, caractérisé en ce que l'on place la structure poreuse dans un précurseur choisi parmi les borazines de formule RBNH dans laquelle R est un halogène ou de l'hydrogène et en ce que l'on chauffe l'ensemble par induction, à une température d'au moins 600°C, sous une pression d'au moins 1,2.10⁵ Pa, de façon à former, par décomposition du précurseur, du nitrure de bore, susceptible de se déposer à l'intérieur des pores de la structure poreuse.

2. Procédé de densification selon la revendication 1, caractérisé en ce que le précurseur est la trichloroborazine.

3. Procédé de densification selon la revendication 1, caractérisé en ce que la structure poreuse est en carbone, graphite, alumine ou nitrure de bore.

4. Procédé de densification selon la revendication 1, caractérisé en ce que la structure poreuse densifiée est soumise à un traitement thermique à une température d'au moins 2000°C.

## Patentansprüche

1. Verfahren zur Verdichtung einer porösen Struktur mit Bornitrid,
**dadurch gekennzeichnet,** daß man die poröse Struktur in einen Zwischenstoff gibt, ausgewählt unter den Borazinen der Formel RBNH, in der R ein Halogen oder Wasserstoff ist, und dadurch, daß man das Ganze durch Induktion erhitzt auf eine Temperatur von wenigstens 600°C unter einem Druck von wenigstens 1,2.10⁵Pa, um durch Zersetzung des Zwischenstoffs Bornitrid zu bilden, das sich im Innern der Poren der porösen Struktur ablagern bzw. niederschlagen kann.

2. Verdichtungsverfahren nach Anspruch 1,
dadurch gekennzeichnet, daß der Zwischenstoff Trichlorborazin ist.

3. Verdichtungsverfahren nach Anspruch 1,
dadurch gekennzeichnet, daß die poröse Struktur ein Kohlenstoff, Graphit, Aluminiumoxid oder Bornitrid ist.

4. Verdichtungsverfahren nach Anspruch 1,
dadurch gekennzeichnet, daß die verdichtete poröse Struktur einer Wärmebehandlung bei einer Temperatur von wenigstens 2000°C unterzogen wird.

## Claims

1. Process for the densification of a porous structure by boron nitride, characterized in that the porous structure is placed in a precursor chosen from among borazenes of formula RBNH, in which R is a halogen or hydrogen and in that heating takes place by induction, at a temperature of at least 600°C, under a pressure of at least 1.2,10⁵ Pa, so as to form, by decomposition of the precursor, born nitride which can be deposited within the pores of the porous structure.

2. Densification process according to claim 1, characterized in that the precursor is trichloroborazene.

3. Densification process according to claim 1, characterized in that the porous structure is of carbon, graphite, alumina or boron nitride.

4. Densification process according to claim 1, characterized in that the densified porous structure undergoes a heat treatment at a temperature of at least 2000°C.
